(19) Europäisches Patentamt
European Patent Office
Office européen des brevets

(11) EP 2 023 408 A1

(12) **EUROPEAN PATENT APPLICATION**
published in accordance with Art. 153(4) EPC

(43) Date of publication:
**11.02.2009 Bulletin 2009/07**

(51) Int Cl.:
*H01L 33/00* (2006.01)    *C03C 3/14* (2006.01)

(21) Application number: **06821820.5**

(22) Date of filing: **05.10.2006**

(86) International application number:
**PCT/JP2006/319985**

(87) International publication number:
**WO 2007/135754 (29.11.2007 Gazette 2007/48)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **18.05.2006 JP 2006139527**

(71) Applicant: **Asahi Glass Company, Limited Chiyoda-ku Tokyo 100-8405 (JP)**

(72) Inventors:
• **NAKAMURA, Nobuhiro Tokyo 100-8405 (JP)**
• **MATSUMOTO, Syuji Tokyo 100-8405 (JP)**

(74) Representative: **Müller-Boré & Partner Patentanwälte Grafinger Strasse 2 81671 München (DE)**

(54) **PROCESS FOR MANUFACTURING LIGHT EMITTING DEVICE AND LIGHT EMITTING DEVICE**

(57)    The present invention provides a process for producing a light-emitting device capable of achieving high directivity without a cavity, which minimizes occurrence of short circuit at a time of covering a light-emitting element with glass. The present invention further provides a light-emitting device capable of achieving high directivity without a cavity.

After a LED mounted on a wiring board is prepared, a glass member having a shape approximated by a rectangular solid or a sphere is placed on the LED. In this step, the glass member is placed so that the central axis of the glass member placed on the LED is present in a region from the central axis of LED to a position inside from the periphery of LED, and that the area of the region is at most 90% of the area of entire surface on which the glass member is placed. Thereafter, the glass member is softened by a heat treatment to cover the LED with the glass member so that a shape that the central axis of LED substantially agrees with the central axis of the glass member in a self-alignment manner.

Fig. 5

**Description**

TECHNICAL FIELD

The present invention relates to a process for producing light-emitting device, and to a light-emitting device, more specifically, to a process for producing a light-emitting device in which a light-emitting element is covered with glass, and to such a light-emitting device.

BACKGROUND ART

Currently, illumination devices employing white light emitting diodes (hereinafter referred to as LED) as light-emitting elements, are becoming to be practically used. White LEDs used for illumination have such merits that 1) power consumption and running cost of white LEDs are less than those of incandescent lamps or fluorescent lamps, 2) lifetime of white LEDs is long and their replacement works can be saved, 3) downsizing is possible, and 4) white LEDs do not employ harmful substances such as mercury.

A white LED usually has a structure that a LED is sealed with a resin. For example, in a case of typical one chip type white LED, a LED having an InGaN layer formed by adding In into GaN as a light-emitting layer, is sealed with a resin containing a YAG fluorescent material. When an electric current flows through the LED, the LED emits blue light. Then, a part of the blue light excites the YAG fluorescent material, and the fluorescent material emits yellow light. Since the blue light and the yellow light are complementary colors from each other, a mixture of these colors is recognized as white color by human eyes.

However, a LED sealed with a resin has such problems that a moisture penetrates into the resin in long time operation and prevents operation of the LED, or light emitted from the LED discolors the resin to deteriorate light transmittance of the resin.

Further, a LED can be used at higher environmental temperature and with higher power input as the thermal resistance from an assembly board to a light-emitting portion is lower and its bearable temperature is higher. Accordingly, the thermal resistance and the heat resistance are key features for achieving high power output of LED. However, when a resin is employed for sealing a LED, there is a problem that since the heat resistance of resin is low, it is not suitable for use with high power output. For example, in a case of epoxy resin, it is yellowed at a temperature of at least 130°C.

To cope with these problems, a LED sealed with a low melting point glass is disclosed (refer to e.g. Patent Documents 1 and 2).

Patent Document 1 discloses a LED lamp wherein a LED element die-bonded to the center of the bottom of concave portion of a reflective bowl, the LED element is connected with a lead portion via a wire bonding portion, and they are sealed with a low-melting-point glass by using e.g. a hot mold.

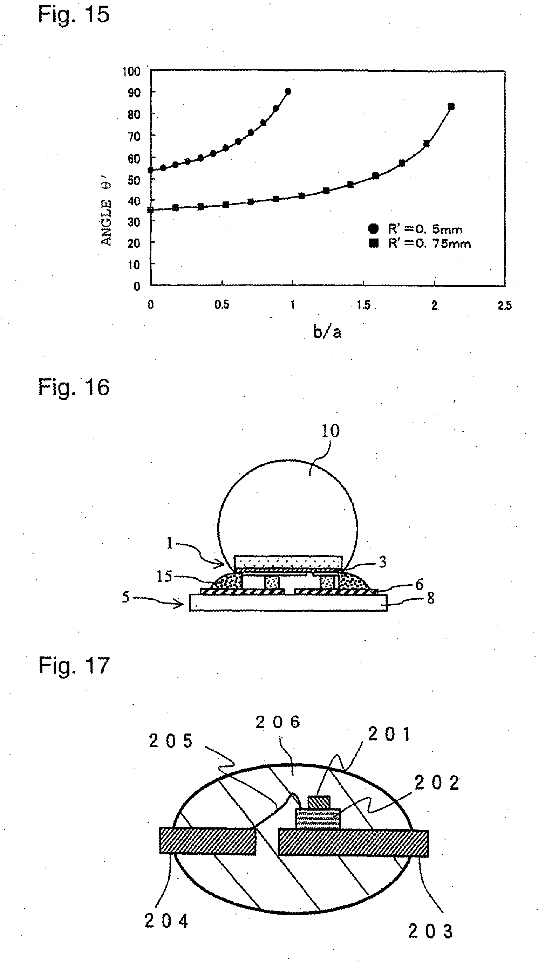

Further, Patent Document 2 discloses a technique of sealing a GaN with a glass by using a mold-press method and an electric furnace. Fig. 17 shows a cross-sectional view of a light-emitting device as an example of such a technique. A light-emitting diode chip 201 mounted on a submount 202 is disposed on a lead 203. Further, the light-emitting diode chip 201 is connected with a lead 204 by a bonding wire 205. Then, the light-emitting diode chip 201 is sealed with a sealing member 206 together with the bonding wire 205. The sealing member 206 is a low-melting-point glass, and by softening the low-melting-point glass by heating, the light-emitting diode chip 201, the bonding wire 205 and a circuit around these members are sealed.

By sealing a LED with a low-melting-point glass, it is possible to reduce moisture-absorption property through the sealing member or deterioration of light-transmittance due to discoloring of sealing member, and to improve heat resistance. Here, "a low-melting-point glass" means a glass material having a deformation point lower than that of typical glass. Commonly, expansion of a glass material is evaluated according to the distance of movement of a detecting portion of a measurement apparatus that is pushed by the glass material when the glass material expands in a uniaxial direction. The deformation point is a temperature at which the glass material becomes too soft to push the detecting portion.

However, in a method of sealing with glass by employing a mold shown in Patent Document 1 or 2, electrode portion of a LED may be deformed by a pressure at a time of molding, to cause a defect. For example, in a construction that a LED is connected with a wiring board via bumps, there are problems that an electrode is shifted or a bump is squashed to cause short circuit between the LED and the wiring board.

In order to solve these problems, a light-emitting device provided with an insulation layer between a LED and a wiring board is proposed (refer to Patent Document 3). In the construction of Patent Document 3, a LED and a wiring board are electrically connected via bumps, followed by filling an insulation layer between the LED and the wiring board. Subsequently by employing a mold, they are pressurized at a predetermined temperature to seal the LED with a low-melting point glass. In this construction, since the under face of the LED and the bumps are fixed by the insulation layer, it is possible to prevent short circuit according to the document.

Further, a light-emitting device is disclosed, in which a buffer layer is provided between a LED and a low-melting point glass to prevent squash of bumps to thereby prevent short circuit (refer to Patent Document 4). According to Patent Document 4, by surrounding a LED with a buffer layer, short circuit due to squash of bumps can be prevented.

Patent Document 1: JP-A-8-102553
Patent Document 2: WO2004/082036
Patent Document 3: JP-A-2006-54210
Patent Document 4: JP-A-2006-54209

DISCLOSURE OF THE INVENTION

PROBLEMS TO BE SOLVED BY THE INVENTION

However, in the light-emitting device disclosed in Patent Document 3 or 4, a step of providing the insulation layer or the buffer layer are newly required. Namely, in the device of Patent Document 2, after a LED is positioned so that the bumps are aligned to a wiring layer, a step of dropping or filling an insulation layer into a gap between a lower face of LED and a wiring board, is required. Further, in the device of Patent Document 3, after a LED is positioned so that its electrodes are aligned to a wiring layer, a step of dropping a liquid resin to form a buffer layer from just above the center portion of LED, is required.

Further, in the light-emitting devices disclosed in Patent Documents 1 to 4, the shape of sealing member in a portion from which light from LED is output, has a semispherical or an oblate shape. For example, in Patent Document 2, a sealing member 206 has an oblate shape (Fig. 17). This is considered to be because the low-melting-point glass has a characteristic that its viscosity radically changes according to the temperature. When the sealing member 206 has such a shape, directivity of light emitted from the light-emitting diode chip 201 is lowered. On the other hand, in applications such as light sources to be employed for optical fibers or projectors, there are strong demands for LEDs having high directivity.

In order to increase directivity of light, a construction is considerable, in which a LED is disposed in a cavity so that light from the LED is reflected by the cavity and the light can be extracted in forward direction. In this case, the cavity is usually made of a ceramic material such as alumina. However, providing such a cavity causes cost up of entire light-emitting device. Further, since a ceramics has a certain degree of light-transmittance, a part of light emitted from a LED is transmitted without being reflected.

The present invention has been made considering these problems. Namely, it is an object of the present invention is to provide a process for producing a light-emitting device, which minimizes occurrence of short circuit at a time of sealing a light-emitting element with glass, and which can realize high directivity without using a cavity.

Further, another object of the present invention is to provide a light-emitting device capable of achieving high directivity without using a cavity.

Other objects and merits of the present invention will be clarified from the following descriptions.

MEANS FOR SOLVING THE PROBLEMS

A first aspect of the present invention relates to a process for producing light-emitting device comprising a step of preparing a light-emitting element mounted on a wiring board, a step of placing on the light-emitting element a glass member approximated by a rectangular solid or a sphere, and a step of softening the glass member by a heating treatment, wherein the central axis of the glass member placed on the light-emitting element is located in a region centered at the central axis of the light-emitting element and ranging to a position inside from the periphery of the light-emitting element, the area of the region is at most 90% of the area of the entire surface on which the glass member is mounted, and the step of softening the glass member is a step of covering the light-emitting element with the glass member to thereby forming a shape in which the central axis of the light-emitting element substantially agrees with the central axis of the glass member by a self-alignment manner.

A second aspect of the present invention relates to a process for producing light-emitting device comprising a step of preparing a light-emitting element mounted on a wiring board, a step of providing a glass paste on the light-emitting element, a step of baking the glass paste to form a glass member, and a step of softening the glass member by a heating treatment, wherein the step of softening the glass member is a step of covering the light-emitting element with the glass member to thereby forming a shape in which the central axis of the light-emitting element substantially agrees with the central axis of the glass member by a self-alignment manner.

A third aspect of the present invention relates to a process for producing light-emitting device comprising a step of preparing a light-emitting element mounted on a wiring board, a step of placing a green sheet on the light-emitting element, a step of baking the green sheet to form a glass member, and a step of softening the glass member by a heating treatment, wherein the step of softening the glass member is a step of covering the light-emitting element with the glass member to thereby forming a shape in which the central axis of the light-emitting element substantially agrees with the central axis of the glass member by a self-alignment manner.

In the first to third aspects of the present invention, it is preferred that the step of preparing a light-emitting element mounted on the wiring board comprises a step of preparing a light-emitting element having a substrate, a semiconductor layer on the substrate and an electrode for applying voltage to the semiconductor layer, and a step of mounting the light-emitting element on the wiring board so that the angle between the substrate and the wiring board becomes at most 1°.

Further, the process may be such that the step of mounting a light-emitting element on a wiring board is a step of electrically connecting the electrode with the wiring board via bumps, and the number of bumps may be at least 3.

Further, the process may be such that the light-emitting element comprises a substrate and a semiconductor layer provided on the substrate; a side face of the substrate has a taper portion within a predetermined vertical range from the face of the substrate on which the semiconductor layer is provided; and the step of softening glass member is a step of covering with the glass member the taper portion of the substrate and a portion above the taper portion.

In the first to third aspects of the present invention, it is preferred that the glass member contains $TeO_2$, $B_2O_3$ and ZnO as main components.

In the first to third aspects of the present invention, the light-emitting element may be any one of an LED and a semiconductor laser.

A fourth aspect of the present invention provides a light-emitting device comprising a wiring board, a light-emitting element having a substrate of rectangular shape in a front view, a semiconductor layer on the substrate, and an electrode electrically connected with the wiring board and for applying voltage to the semiconductor layer; and a glass member for covering the light-emitting element; wherein entirety of the glass member is substantially spherical, the light-emitting element is embedded in a part of the glass member, a curved face of the glass member contacts with a side face of the light-emitting element, and a radius R of a sphere approximating the glass member and the length L of a diagonal line of the substrate satisfy a relation:

$$L < 2R \leqq 3L.$$

A fifth aspect of the present invention provides a light-emitting device comprising a wiring board; a light-emitting element having a substrate of rhombic shape or parallelogram shape in a front view, a semiconductor layer on the substrate, and an electrode electrically connected with the wiring board and for applying voltage to the semiconductor layer; and a glass member for covering the light-emitting element; wherein entirety of the glass member is substantially spherical, the light-emitting element is embedded in a part of the glass member, a curved face of the glass member contacts with a side face of the light-emitting element, and a radius R of a sphere approximating the glass member and the length L of one of diagonal lines whichever longer of the substrate satisfy a relation:

$$L < 2R \leqq 3L.$$

In the fourth and fifth aspects of the present invention, it is preferred that the glass member contains $TeO_2$, $B_2O_3$ and ZnO as main components.

In the fourth and fifth aspects of the present invention, the light-emitting element may be any one of an LED and a semiconductor laser.

EFFECTS OF THE INVENTION

According to the first aspect of the present invention, by softening a glass member and covering a light-emitting element with the glass member to form a shape in which the central axis of the light-emitting element substantially agrees with the central axis of the glass member in a self-alignment manner, it is possible to produce a light-emitting device capable of achieving high directivity without using a cavity while generation of short circuit at the time of covering the light-emitting element with glass is minimized. Further, the central axis of the glass member placed on the light-emitting element is present in a region from the central axis of the light-emitting element to a position inside from the periphery of the light-emitting element, and the area of this region is at most 90% of the area of a face on which the glass member is placed, and accordingly, it is not necessary to align the light-emitting element and the glass member precisely before heating.

According to the second aspect of the present invention, by softening a glass member and covering a light-emitting element with the glass member to form a shape in which the central axis of the light-emitting element substantially agrees with the central axis of the glass member in a self-alignment manner, it is possible to produce a light-emitting device capable of achieving high directivity without using a cavity while generation of short circuit at the time of covering the light-emitting element with glass is minimized.

According to the third aspect of the present invention, by softening a glass member and covering a light-emitting element with the glass member to form a shape in which the central axis of the light-emitting element substantially agrees with the central axis of the glass member in a self-alignment manner, it is possible to produce a light-emitting device capable of achieving high directivity without using a cavity while generation of short circuit at the time of covering the light-emitting element with glass is minimized.

According to the fourth aspect of the present invention, a light-emitting element is embedded in a part of a glass whose entirety is substantially spherical, a curved face of the glass contacts with side faces of the light-emitting element, and a radius R of a sphere when the glass member is approximated by the sphere, and a length $L_1$ of a diagonal line of a substrate constituting the light-emitting element, satisfy a relation:

$$L_1 < 2R \leqq 3L_1,$$

and accordingly, it is possible to achieve a light-emitting device capable of achieving high directivity without using a cavity.

According to the fifth aspect of the present invention, a light-emitting element is embedded in a part of a glass whose entirety is substantially spherical, a curved face of the glass contacts with side faces of the light-emitting element, and a radius R of a sphere when the glass member is approximated by the sphere, and a length $L_2$ of a diagonal line of a substrate constituting the light-emitting element, satisfy a relation:

$$L_2 < 2R \leqq 3L_2,$$

and accordingly, it is possible to achieve a light-emitting device capable of achieving high directivity without using a cavity.

BRIEF DESCRIPTION OF DRAWINGS

Fig. 1: A flowchart showing the process for producing light-emitting device in an embodiment of the present invention.
Fig. 2: A view explaining the process for producing light-emitting device in this embodiment.
Figs. 3 (a) and 3(b): Views explaining the process for producing light-emitting device of this embodiment.
Fig. 4: A view explaining the process for producing light-emitting device in this embodiment.
Fig. 5: A view explaining the process for producing light-emitting device in this embodiment.
Fig. 6: A view explaining the process for producing light-emitting device in this embodiment.
Fig. 7: A view explaining the process for producing light-emitting device in this embodiment.
Fig. 8: A cross-sectional view of a LED substrate applicable to this embodiment.
Fig. 9: Temperature profiles of heating by infrared rays and heating by an electric furnace.
Fig. 10: An explanation view of characteristics of light output from a spherical surface.
Fig. 11: A example of a cross-sectional view of a light-emitting device of this embodiment.
Fig. 12: A cross-sectional view of the light-emitting device of Fig. 11 observed from a direction 45° shifted from that of Fig. 11.
Fig. 13: A partial cross-sectional view of the light-emitting device of this embodiment.
Fig. 14: A plan view of the light-emitting device of Fig. 13 observed from LED side.
Fig. 15: A view showing a relation between (b/a) and an angle θ' in this embodiment.
Fig. 16: A view explaining a process for producing a light-emitting device in this embodiment.
Fig. 17: A cross-sectional view of a conventional light-emitting device.

EXPLANATION OF NUMERALS

| 1, 22, 32, 101: | LED |
| 2, 8, | 102: substrate |
| 3: | semiconductor layer |
| 4: | electrode |
| 5, 24: | wiring board |
| 6, 25: | wiring |
| 7, 26: | bump |

| 9, 23, | 31: glass member |
| 10; 14: | cover glass |
| 11, 13, 21: | light-emitting device |
| 12: | taper portion |
| 15: | sealing resin |
| 103: | n-type semiconductor layer |
| 104: | p-type semiconductor layer |
| 105: | p-type electrode |
| 106: | light-emitting layer |
| 107: | n-type electrode |

BEST MODE FOR CARRYING OUT THE INVENTION

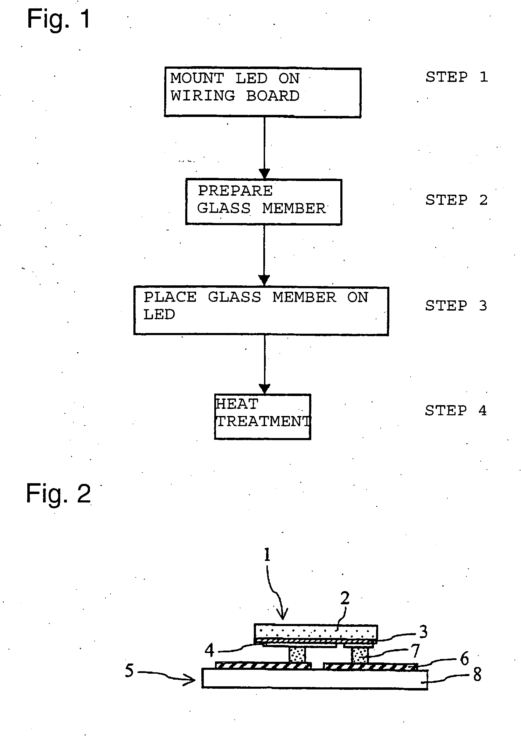

Fig. 1 is a flowchart showing a process for producing light-emitting device of this mode (hereinafter referred to as this embodiment). Further, Figs. 2 to 15 are views explaining the process for producing light-emitting device. Here, in these figures, portion having a sam symbol are the same elements.

First, as shown in Fig. 2, a LED mounted on a wiring board is prepared (step 1).

In this embodiment, a LED 1 is a semiconductor chip having a rectangular shape in a front view, Here, the LED 1 may be a semiconductor chip of rhombic or parallelogram shape in a front view.

The LED 1 has a substrate 2, a semiconductor layer 3 formed on the substrate 2, and an electrode 4 formed on the semiconductor layer 3. The semiconductor layer 3 is an epitaxial layer having a p-type semiconductor layer and a n-type semiconductor layer. Further, the electrode 4 is constituted by a p-type electrode, and a n-type electrode. The electrode 4 is electrically connected with a wiring 6 on a substrate 5 via bumps 7, and when a voltage is applied to the semiconductor layer 3 through the electrode 4, light is emitted from the vicinity of pn-junction (not shown).

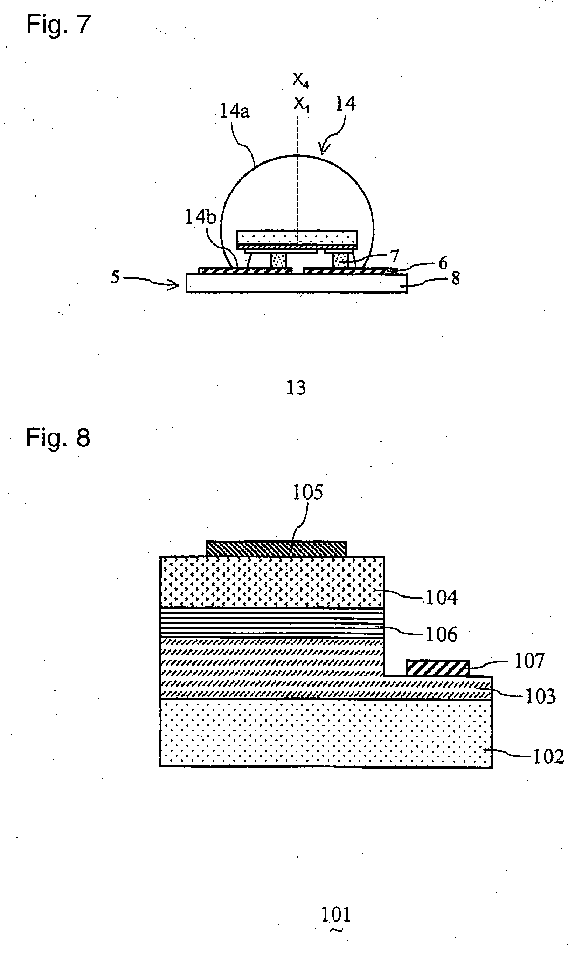

Fig. 8 is an example of cross-sectional view of a LED applicable to this embodiment. In this figure, a LED 101 has a construction having a substrate 102, a n-type semiconductor layer 103 formed on the substrate 102, and a p-type semiconductor layer 104 formed above the n-type semiconductor layer 103. Then, on the p-type semiconductor layer 104, a p-type electrode 105 is formed. Further, a part of the p-type semiconductor layer 104 and a part of a light-emitting layer 106 formed between the n-type semiconductor layer 103 and the p-type semiconductor layer 104, are removed, and a n-type electrode 107 is formed on the n-type semiconductor layer 103 thus exposed to the outside.

Here, in Fig. 2, the electrodes 4 are all disposed on the same horizontal line in relation to the substrate 2. On the other hand, when the LED substrate 101 of Fig. 8 is employed, the n-type electrode 107 is, as described above, formed after a part of semiconductor layers are removed. For this reason, strictly speaking the p-type electrode 105 and the n-type electrode 107 are not on the same horizontal line in relation to the substrate 102. However, in this embodiment, whether or not the p-type electrode and the n-type electrode are located on the same horizontal line, is not particularly distinguished.

In Fig. 8, when a voltage is applied between the p-type electrode 105 and the n-type electrode 107, since energy difference between the p-type semiconductor 104 and the n-type semiconductor 103 becomes small, electrons move from then-type semiconductor 103 to the p-type semiconductor 104 to couple with holes. Energy discharged at this time is visually recognized as light emission of LED.

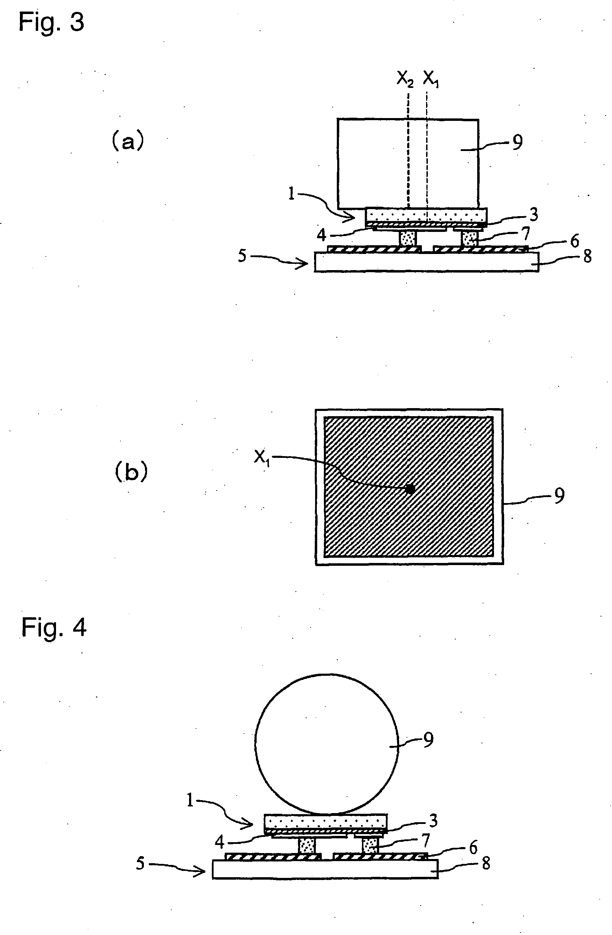

As the LED 1, one not deteriorated by a heat treatment at a time of covering with a glass member 9 (refer to Fig. 3) is employed. Since generally, one having a large band gap has high heat resistance, a LED emitting blue light is preferably employed. For example, a LED having a main emission peak wavelength of at most 500 nm, more specifically, a LED employing a nitride semiconductor such as GaN or InGaN, or a group II-VI compound semiconductor such as ZnO or ZnS, is mentioned.

For example, a sapphire substrate is employed as the substrate 102, a n-GaN layer is employed as the n-type semiconductor layer 103, and a p-GaN layer is employed as the p-type semiconductor layer 104. Further, a InGaN layer is employed as the light-emitting layer 106, and the structure of the emission portion may be a single or a multi quantum well structure. In this case, from the light-emit-ting layer 106, UV light of at most 420 nm is emitted. Here, between the sapphire substrate and the n-GaN layer, a buffer layer such as a AIN layer or a GaN layer is preferably provided. This is because the sapphire substrate and the GaN layer are significantly different in lattice constant and thermal expansion coefficient.

In a case of providing a buffer layer, a stress formed in a cooling step after annealing may cause e.g. cracks in the sapphire substrate. To avoid this problem, it is necessary to make the sapphire substrate have a certain thickness (for example, at least 300 $\mu$m). However, since it is generally difficult to cut a substrate of such a thickness by dicing, it is preferred to polish the sapphire substrate to reduce the thickness before dicing. For example, in a case of a LED substrate of 2 inches and about 635 $\mu$m thick before dicing, the sapphire substrate is polished to reduce the thickness to about 100 $\mu$m before dicing.

A material for forming the p-type electrode 105 or the n-type electrode 107 may, for example, be gold (Au), platinum (Pt), silver (Ag) or aluminum (A1). Among these, from the viewpoint of high melting point and resistance to e.g. oxidation, gold is preferred. Here, a semiconductor device such as LED may employ an electrode disclosed in e.g. JP-A-2002-151737, JP-A-10-303407 or JP-A-2005-136415, which has a layer structure employing a predetermined material to improve heat resistance. This is because at a time of covering a LED chip with a glass member, the LED chip is subjected to heat treatment in an atmospheric air at a high temperature, and thus, it is necessary to avoid deformation or oxidation of an electrode by heat.

The light-emitting device of the present invention may be employed also in a case where a light-emitting element is not a LED but a semiconductor laser. As the semiconductor laser, in the same manner as LED, one not deteriorated by a heat treatment for sealing the element with a sealing glass, is employed. Namely, a semiconductor laser having a main emission peak wavelength of at most 500 nm, more specifically, a semiconductor laser employing a nitride semiconductor such as GaN or InGaN, or a Group II-VI compound semiconductor such as ZnO or ZnS, may be employed.

In Fig. 2, a wiring board 5 has a substrate 8 and wiring 6 formed on the substrate 8. The wiring board may, for example, be formed by screen printing the substrate 8 with a wiring material, and subjecting the substrate 8 to a heating treatment.

The substrate 8 is preferably one having high heat resistance. This is because at a time of covering a LED 1 with a glass member 9, it is necessary to heat the glass member 9 at a temperature higher than the softening point of glass. For this reason, a resin substrate made of e.g. an epoxy resin is not preferred, since it may undergo deterioration due to heat. A heat-resistant substrate applicable to this embodiment may, for example, be a ceramic substrate such as an alumina substrate, an aluminum nitride substrate or a silicon carbide substrate, a glass ceramic substrate or a silicon substrate (silica-coated silicon substrate) on which a silicon oxide film is formed.

In a light-emitting device having a structure that a glass member for sealing LED contacts with a wiring board, the heat expansion coefficient of the wiring board is preferably close to the heat expansion coefficient of the glass member. When the difference between these coefficients are large, defects such as exfoliation between the glass member and the wiring board tends to occur. For this reason, in such a light-emitting device, it is preferred that the heat expansion coefficient $\alpha_1$ of glass member and a heat expansion coefficient $\alpha_2$ of wiring board satisfy a relation that $|\alpha_1 - \alpha_2| \leqq 5 \times 10^{-7}$ (/°C).

The wring material may, for example, be gold (Au), platinum (Pt), silver (Ag) or aluminum (A1). Among these, from the viewpoint of high melting point and resistance to e.g. oxidation, gold is preferably employed. This is because at a time of covering a LED 1 with a glass member 9, the LED 1 is subjected to a heat treatment in an atmospheric air at a high temperature, and it is necessary to avoid deformation or oxidation of wiring 6 due to heat.

The wiring material may contain a glass component. In a light-emitting device having a structure that a glass member sealing a LED contacts with a wiring board, the glass component contained in the wiring material enables to adhere the wiring board with the glass member with high adhesive force. The glass component in this case may, for example, be one containing $SiO_2$, $Bi_2O_3$ ZnO or $B_2O_3$. Further, the glass component preferably contains substantially no lead from the viewpoint of environmental issue. Further, from the viewpoint of preventing deterioration of electrical characteristics of the light-emitting device, the glass component preferably contains substantially no alkali.

Here, the wiring material may contain another component other than the glass component. For example, in a case of forming a wiring pattern by screen printing, for the purpose of viscosity adjustment and uniform dispersion of glass component in gold, a varnish may be added. In this case, the varnish is preferably one that can be decomposed and evaporated by heat, specifically, an organic varnish may be employed.

Further, for the purpose of increasing adhesive force between the wiring board and the glass member, an adhesive material disclosed in Japanese Patent Application 2005-254127 of the present inventors may be provided. Namely, by providing the material between the wiring board and the glass member so as to encompass the periphery of LED, it becomes possible to reduce intrusion of moisture through an interface between the glass member and the wiring board. In this case, the adhesive material contains a glass component and the glass component may be the same as the glass component contained in the wiring material, or it may be different. Here, from the viewpoint of environmental issue, the glass component preferably contains substantially no lead, and from the viewpoint of preventing deterioration of electrical characteristics of the light-emitting device, the glass component preferably contains substantially no alkali in the same manner as above.

Mounting of the LED 1 on the wiring board 5 is carried out by electrically connecting the electrode 4 provided on the LED 1 witch the wiring 6. The method of connection may be any one of wire-bonding method or wireless bonding method, but in the case of the wire-bonding method, an air may be enclosed in a wire portion to cause a bubble in the glass member, and accordingly, the wireless bonding method is preferred.

In this embodiment, they are mounted by a flip chip method. Namely, first of all, bumps 7 are formed on electrodes 4, and the electrodes 4 are connected with wiring 6 via the bumps 7. By this method, a construction shown in Fig. 2 is obtained. Here, the LED 1 is preferably mounted so that the substrate 2 becomes substantially parallel with the wiring board 5. Specifically, the angle between the substrate 2 and the wiring board 5 is preferably at most 1°. If the LED 1 is mounted in a state that the substrate 2 is tilted in relation to the wiring board 5, emission light from the LED 1 is tilted. To avoid this problem, it is preferred to provide at least three bumps 7 to prevent tilting of the substrate 2 at the time of mounting. By this method, it is possible to prevent the LED 1 from being tilted when the glass member 9 is softened. Here, such an effect can not be obtained when there is a variation in the height of bumps 7, and accordingly, it is necessary to reduce the variation. Further, the effect may change according to the distance between bumps 7, it is also necessary to set a proper distance according to the specification of the device.

Also as the material for forming bumps 7, gold is preferably employed. Here, when electricity is flowed through light-emitting device under high temperature high humidity environment, and when different types of metals are employed for the electrodes 4, the bumps 7 and the wiring 6, corrosion of these materials may occur. On the other hand, when these members are all made of gold, such a problem does not occur. Accordingly, it is preferred that gold is employed for all of the electrodes 4, the bumps 7 and the wiring 6.

Then, a glass member 9 for covering the LED 1 is prepared (step 2). Here, the order between step 1 and step 2 does not matter.

The glass member 9 employed has a softening point of at most 500°C, preferably at most 490°C, an average linear expansion coefficient of from $65 \times 10^{-7}/°C$ to $95 \times 10^{-7}/°C$ in a temperature range of from 50°C to 300°C, an internal transmittance of at least 80%, preferably at least 85%, more preferably at least 90%, further preferably at least 93% per 1 mm thick for light of 405 nm wavelength, and a refractive index of at least 1.7, preferably at least 1.9, more preferably at least 2.0 for the above light. Particularly, one having a softening point of at most 500°C, an average linear expansion coefficient of from $65 \times 10^{-7}/°C$ to $95 \times 10^{-7}/°C$ in a temperature range of from 50°C to 300°C, an internal transmittance of at least 80% per 1 mm thick for light of 405 nm wavelength, and a refractive index of at least 1.8 for this light, is preferred. When such a glass is employed, since the difference from LED 1 in thermal expansion coefficient is small, it is possible to reduce residual stress and to prevent generation of a crack in a glass after sealing. Further, since such a glass has high transmittance and high refractive index, it is possible to cover the LED 1 without deteriorating extraction efficiency of light emitted from the LED 1.

The glass member 9 of this embodiment is preferably one containing $TeO_2$, $B_2O_3$ and ZnO, and among such glass members, particularly preferably one containing at least 10 mol%, preferably from 40 mol% to 54 mol% of $TeO_2$. By increasing the content of $TeO_2$ it becomes possible to increase refractive index.

Specifically, one in which the total content of $TeO_2$ and $GeO_2$ is from 42 mol% to 58 mol%, the total content of $B_2O_3$, $Ga_2O_3$ and $Bi_2O_3$ is from 15 mol% to 35 mol%, the content of ZnO is from 3 mol% to 20 mol%, the total content of $Y_2O_3$, $La_2O_3$, $Gd_2O_3$ and $Ta_2O_5$ is from 1 mol% to 15 mol%, and the total content of $TeO_2$ and $B_2O_3$ is at most 75 mol%, may be employed.

Among these, particularly one in which the content of $TeO_2$ is from 40 mol% to 53 mol%, the content of $GeO_2$ is from 0 mol% to 10 mol%, the content of $B_2O_3$ is from 5 mol% to 30 mol%, the content of $Ga_2O_3$ is from 0 mol% to 10 mol%, the content of $Bi_2O_3$ is from 0 mol% to 10 mol%, the content of ZnO is from 3 mol% to 20 mol%, the content of $Y_2O_3$ is from 0 mol% to 3 mol%, the content of $La_2O_3$ is from 0 mol% to 3 mol%, the content of $Gd_2O_3$ is from 0 mol% to 7 mol%, and the content of $Ta_2O_5$ is from 0 mol% to 5 mol%, is preferably employed.

For example, a glass member 9 employed may be composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_5$ (3.0 mol%). This composition contains no alkali metal, it has a relatively low softening point (e.g. about 490°C) and it has an average linear expansion coefficient of about $86 \times 10^{-7}/°C$. Accordingly, it is close to the average linear expansion coefficient ($68 \times 10^{-7}/°C$ in parallel with C axis, $52 \times 10^{-7}/°C$ perpendicularly to C axis) of a sapphire substrate commonly used for LED. Further, since the glass member has a high refractive index of 2.01 at a wavelength 405 nm, such a property increases extraction efficiency of emission light from LED 1, and improves directivity of light.

The glass member 9 may contain a fluorescent material. For example, when a fluorescent material emitting yellow light is added to the glass member, blue light emitted from the LED 1 is mixed with yellow light emitted from the fluorescent material excited by a part of the blue light, to produce white light. Here, when the fluorescent material is added, the fluorescent material scatters light to reduce directivity. However, according to the present invention, since a light-emitting device in which the central axis of LED 1 substantially agrees with the central axis of the glass member 9 can be constructed, white emission light having the same color tone to all directions can be obtained.

The glass member 9 preferably contains substantially no lead from the viewpoint of environmental issue. Further, from the viewpoint of preventing deterioration of electrical characteristic of LED 1, the glass member 9 preferably contains substantially no alkali.

The glass member 9 is fabricated into a shape placable on the LED 1. In this embodiment, the glass member 9 is a glass member having a shape approximated by a rectangular solid. However, it may be a glass member having a shape approximated by a sphere.

For example, a glass raw material containing $TeO_2$, $B_2O_3$ and ZnO as main components is put in a crucible made of gold, it is heated to be melted, and stirred by a stirrer made of gold to unify the material to obtain a molten glass.

Then, the molten glass is flowed out into a carbon mold, to obtain a glass piece formed into a block shape or spherical shape to be employed. In this case, the shape of the glass member 9 is not necessarily constant, but considering an automation process that is expected in a mass production stage, the shape is preferably constant. Further, from the viewpoint of reducing bubbles produced at the time of melting, the surface of glass member is preferably a mirror surface. For example, a front surface and a rear surface of a glass piece cut into an appropriate size are subjected to optical polishing, and further precisely cut into a desired shape to obtain a block-shaped glass, and such glass may be employed as the glass member 9.

Then, as shown in Fig. 3(a), the glass member 9 is placed on the LED 1 (step 3).

The amount of glass member 9 to be placed on the LED 1 is an amount required for covering the LED 1. Specifically, it is an amount capable of covering a portion from which light of LED 1 is extracted, that is a portion other than the electrode face, with a thickness of at least a few times of wavelength of visible light, specifically, with a thickness of at least 2 $\mu$m. Here, if the volume of glass member 9 protruding from the LED 1 is large when the glass member 9 is placed on the LED 1, the glass member 9 may drop from the LED 1 without covering the LED 1 when the glass member is softened in a subsequent step. By approximating the shape of the glass member 9 by a rectangular solid or a sphere, it is possible to relatively reduce the volume of the glass member 9 protruding from the LED 1.

In Fig. 3(a), the central axis $X_1$ of LED 1 does not agree with the central axis $X_2$ of the glass member 9. In this embodiment, the glass member 9 may be placed so that these axes agree with each other, but they are not necessarily agree with each other as shown in Fig. 3(a). Namely, in the step of placing the glass member 9, it is not necessary to precisely align it to the LED 1. It is sufficient that the central axis $X_2$ of the glass member 9 placed on the LED 1 is present in a region from the central axis $X_1$ of LED 1 to a position inside of the periphery of the LED 1, and that the area of this region is at most 90%, preferably at most 80% of the area of an entire surface on which the glass member is placed. Here, the central axis of LED 1 is assumed to agree or substantially agree with the optical axis of LED 1. The central axis $X_2$ of the glass member 9 is assumed to be the same direction of LED $X_1$. The reason why the central axis $X_1$ of the LED 1 is defined as the center of the region is because when the central axis $X_2$ of the glass member 9 is present in the vicinity of the periphery of LED 1, the glass member 9 may drop off the LED 1.

The above condition may also be defined that provided that the distance from the central axis $X_1$ of LED 1 to the central axis $X_2$ of glass member 9 on a straight line connecting the central axis $X_1$ of LED 1, the central axis $X_2$ of glass member 9 and the periphery of LED 1, is designated as $d_1$, and the distance from the central axis $X_2$ of glass member 9 to the periphery of LED 1 on the straight line is designated as $d_2$, then, $0 \leq d_1/(d_1+d_2) \leq 0.9$, more preferably $0 \leq d_1/(d_1+d_2) \leq 0.8$ is satisfied. Here, $d_1/(d_1+d_2)=0$ is satisfied when the central axis $X_1$ of LED 1 agrees with the central axis $X_2$ of glass member 9.

Fig. 3(b) is a plan view of LED 1 observed from the side of substrate 2. In this figure, the shaded region corresponds to a region from the central axis $X_1$ of LED 1 to a position inside of the periphery. Further, when the ratio of the area of the shaded region is 90% basted on the area of the entire surface on which the glass member 9 is placed, it is sufficient that the glass member 9 is place so that the central axis $X_2$ of the glass member 9 is positioned in the shaded region.

When it is difficult to place the glass member 9 on the LED 1, the glass member 9 may be fixed by using a vehicle obtained by mixing an appropriate resin and solvent. In this case, component constituting the vehicle is one that can be at least decomposed and evaporated by a heat treatment for covering the LED 1 with the glass member 9.

In this embodiment, the glass member 9 may be formed also by printing a glass paste on the LED 1 and carrying out a heat treatment.

The glass paste contains a glass frit, a resin having a binder function and a solvent as main components. As the glass frit, a glass powder made of the above-mentioned glass component is preferably employed.

Further, the heating treatment is constituted by a first heating treatment of low temperature for evaporating the solvent in the glass paste and a second heating treatment of high temperature for baking the glass paste. The first heating treatment and the second heating treatment may be carried out continuously, or after the first heat treatment, the temperature may be once lowered before carrying out the second heat treatment. Further, the second heat treatment is constituted by a binder-removal treatment for decomposing and evaporating the resin and a baking treatment for sintering and softening the glass powder. The binder removal treatment and the baking treatment are carried out continuously. The temperature range of the baking treatment is preferably a range from the softening temperature of glass to a temperature about 200°C higher than the softening temperature. Since the shape or size of bubbles remaining in a glass after baking changes depending on the temperature of baking treatment, it is preferred to carry out the baking at an appropriate temperature considering this factor. After the baking is completed, a cooling is carried out at an appropriate temperature-dropping speed. By this process, it is possible to form a glass member 9 on the LED.

Further, in this embodiment, a glass member 9 may be formed also by employing a green sheet.

The green sheet is obtainable by coating a supporting film such as a polyethylene terephthalate film with a composition that is similar to the above glass paste, evaporating a solvent to produce a film-shaped glass composition and peeling off the supporting film. By placing the green sheet on the LED 1 and carrying out a heat treatment, a glass member 9 can be formed on the LED 1. Here, the heat treatment corresponds to the above baking treatment, and is constituted by a binder-removal treatment for decomposing and evaporating a resin and a baking treatment for sintering and softening a glass powder. These treatments are continuously carried out by using e.g. an electric furnace.

By the way, in a case of obtaining a glass member of large volume from a molten glass, it is sufficient to mold the molten glass into a glass piece of a size of necessary amount at the time of molding the molten glass into a block shape or a spherical shape. On the other hand, in a case of employing a glass paste or a green sheet, it is possible to increase the volume of glass member by laminating these sheets to form the glass member.

For example, in a case of employing a glass paste, the thickness of glass member obtainable by one screen printing step is about from 5 $\mu$m to 30 $\mu$m. However, by increasing the number of printing steps, and laminating the glass paste formed by printing, it is possible to produce a glass member having large film thickness. Further, instead of a screen printing method, a doctor blade printing method or a die coat printing method may be used to for a glass member of.large film thickness. Meanwhile, in a case of employing a green sheet, a glass member having a thickness of from about 50 $\mu$m to 400 $\mu$m can be formed. Then, also in this case, by laminating such a green sheet, a glass member having further large film thickness can be formed.

Then, the glass member 9 is softened by a heat treatment (step 4). The present invention is characterized in that in this step, the LED 1 is covered with the glass member 9 and a shape that the center of LED 1 substantially agrees with the central axis of glass member 9 is formed in a self-alignment manner.

The heating temperature is a temperature higher than the softening point of the glass member 9. This temperature is determined according to the composition of glass member 9. For example, when the glass member 9 is composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_3$ (3.0 mol%), the heating temperature is set to be higher than 500°C, preferably higher than 570°C.

Further, the heating temperature needs to be lower than a temperature causing trouble of operation of the LED 1. Specifically, the heating temperature is preferably at most 700°C, more preferably at most 630°C. When the temperature exceeds 700°C, the light-emission function of the LED 1 may be deteriorated.

In this embodiment, by carrying out a heating treatment in an atmosphere of predetermined temperature by using e.g. an electric furnace, it is possible to soften the glass member 9. Further, also by carrying out a local heating by using an infrared-condensing heating apparatus or a hot plate, and by using thermal conduction from a heated portion, the glass member can be softened. In the case of e.g. an electric furnace, it is possible to raise the temperatures of glass member 9 and LED 1 uniformly. On the other hand, in the case of only using e.g. an infrared-condensing heating apparatus, the treatment time can be reduced as compared with that of e.g. an electric furnace, and it is possible to improve productivity of the light-emitting device.

Here, a Japanese Patent Application 2006-111089 by the present applicant proposes a structure and a production process of a glass-sealed light-emitting element. Further, a Japanese Patent Application 2006-072612 proposes a process for producing a light-emitting element employing an infrared-condensing heating apparatus. Any one of these heating methods can be applied to the present invention.

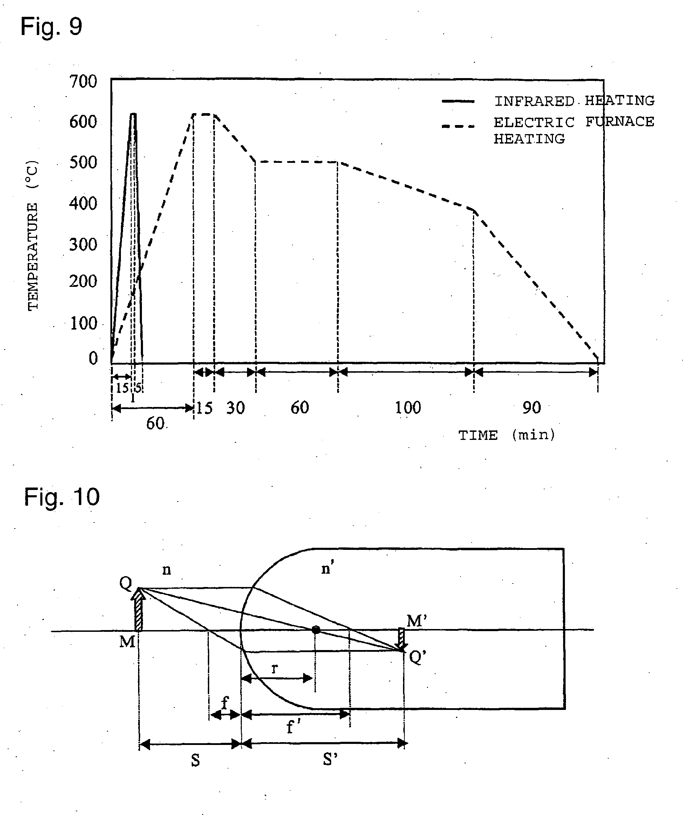

Fig. 9 is an example of comparison of temperature profiles of the methods using an electric furnace and an infrared-condensing heating apparatus. Here, in this example, an electric furnace (product name: FP41) manufactured by Yamato Scientific Co., Ltd. or an infrared heating apparatus IVF298W (product name) manufactured by Thermo Riko Co., Ltd. was employed.

In the case of using the electric furnace, as shown in the broken line in Fig. 9, the temperature was raised from a room temperature to 610°C in 60 min, it was maintained at 610°C for 15 min, and lowered to the temperature in at least 4 hours. On the other hand, in a case of using the infrared-condensing heating apparatus, as shown in the solid line in Fig. 9, the temperature was raised from a room temperature to 630°C in 15 min, it was maintained at 630°C for 1 min, and it was lowered to the room temperature in 5 min. Thus by using the infrared-condensing heating apparatus, as compared with a case of employing an electric furnace, it becomes possible to shorten both temperature-raising time and temperature-lowering time.

However, in this embodiment, it is not preferred to extremely shorten the above heating time. When an organic material unnecessary for the light-emitting device is adhered to any one of the glass member 9, the LED 1 and the wiring board 5, the heating step functions to remove the organic material. For example, when a vehicle is employed to fix the glass member 9 on the LED 1, the heating time needs to be long enough to decompose and remove the vehicle. Further, when a glass paste or a green sheet is employed, the heating time needs to be long enough to decompose and remove a solvent or a resin. In these cases, when an infrared-condensing heating apparatus is used, the heating time is preferably at least 5 min.

Meanwhile, a cooling time after the heating is preferably at least 5 min and at most 5 hours. If the cooling time is too short, compressive stress is formed on a surface of the glass member 9 while a tensile stress is formed inside of the glass member 9, and as a result, the glass member 9 becomes fragile and a crack tends to be formed. On the other hand, if the cooling time is too long, thermal damage to the LED 1 may increase.

When the temperature of the glass member 9 is raised by the heating treatment, softening of the glass member 9 starts. At this time, if the volume ratio of glass member 9 based on LED 1 is at most a predetermined value, a softened glass member 9 forms a shape close to a sphere on the LED 1 by its surface tension as shown in Fig. 4. Thereafter, the glass member 9 moves downwardly so as to cover the LED 1 by deformation due to its own weight. On the other hand, if the volume ratio of glass member 9 based on LED 1 is larger than the predetermined value, the glass member. 9 becomes, without having a step of forming a spherical shape on the LED 1, to have a shape close to a sphere as it moves downwardly, so as to cover the LED 1.

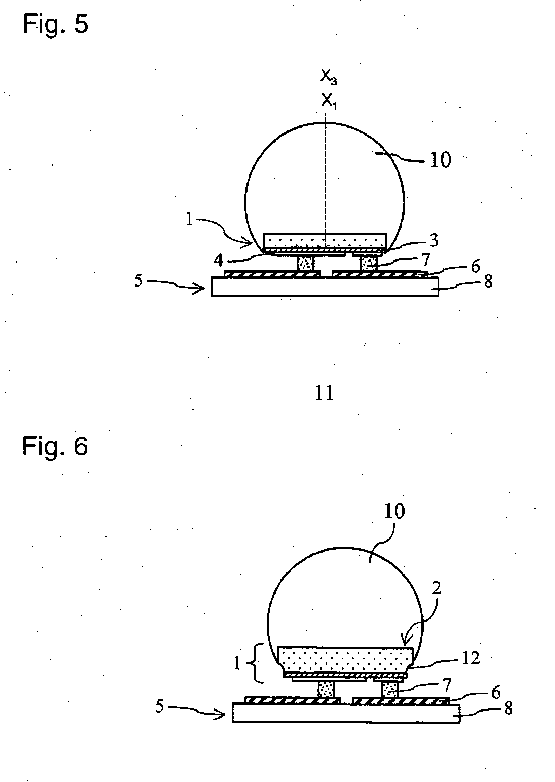

In each of these cases, the glass member 9 moved downwardly stops at a lower end of each side wall of LED 1. Thereafter, a shape that the central axis of the glass member 9 substantially agrees with the central axis of the LED 1, is formed in a self-alignment manner. When they are cooled in this state, a light-emitting device 11 shown in Fig. 5 is obtained.

In the light-emitting device 11 of Fig. 5, a LED 1 is embedded in a part of glass member 9 whose entirety is substantially spherical, and a curved face of the glass member 9 contacts with side faces of the LED 1. Here, in this embodiment, a glass member 9 covering a LED is referred to as a cover glass 10 to distinguish for convenience.

The above self-alignment process is specifically described as follows. Here, the description only shows an example of change of a glass member 9 after it is softened, and the description does not limit a behavior of the glass member 9 of the present invention.

When a glass member 9 is softened on a LED 1, the glass member 9 behaves as if it flows out downwardly from the upper face of the LED 1. In this case, the glass member 9 is not necessarily flows out isotropically, but unevenness tends to occur depending on the shape of glass member 9 or the position on which the glass member 9 is placed. Then, when the glass member 9 at first starts to flow out from one side of the LED 1, the glass member 9 flows out downwardly along a side wall of the LED 1, and stops at the lower end of the side wall. Subsequently, the glass member 9 flowed out from the other sides also stop at the lower end of the side wall in the same manner. At this time, when the amounts of glass member 9 flowed out from the respective sides are different, the glass member 9 moves so as to entirely balance the glass member 9. Then, the glass member 9. is stabilized at a position where the amount of the glass member 9 on the entire LED 1 is balanced, that is a position where the central axis of the glass member 9 agrees with the central axis of LED 1, to form a stable shape. Accordingly, even without carrying out precise position alignment of the glass member 9 to the LED 1 before heating, the shape of Fig. 5 is obtained in a self-alignment manner. Thereafter, by lowering the temperature, the shape can be solidified. In Fig. 5, the central axis $X_3$ of cover glass 10 substantially agrees with the central axis $X_1$ of LED 1.

For such a self-alignment process, particularly, a heat treatment employing an electric furnace is suitable. An electric furnace can raise the temperatures of the glass member 9 and the LED 1 uniformly. Further, since it takes longer time for such an electric furnace to heat the glass member 9 as compared with heating by e.g. an infrared-condensing heating apparatus, it is possible to soften the glass member 9 relative slowly. For this reason, the glass member 9 is considered to move slowly so as to balance itself and to cover the entire LED 1 uniformly. Such a behavior is desirable to form a shape in which the central axis of LED 1 substantially agrees with the central axis of glass member 9 in a self-alignment manner.

A position where the softened glass member 9 stops in the self-alignment process can be controlled by the shape of LED 1. By this method, the distance from a light-emitting layer of LED 1 to a surface of glass member 9 that is a portion functioning as a lens, can be changed, and accordingly, it becomes possible to change an output angle. For example, as shown in Fig. 6, by forming a taper in a part of a substrate 2 constituting the LED 1, specifically, a taper is formed within a predetermined vertical range from the face of the substrate 2 on which a semiconductor layer 3 is provided, it is possible to stop the glass member 9 at the taper portion 12. Such a taper shape can be formed at a time of polishing the substrate 2 constituting the LED 1. In the example of Fig. 6, the diameter of a sphere when the glass member 9 is approximated by the sphere may be from 0.5 mm to 1.0 mm, the thickness of the substrate 2 may be about 100 $\mu$m, and the thickness.of the taper portion 12 may be about 15 $\mu$m. Further, the substrate 2 may be a square of about 320 $\mu$m in a front view. By such a construction, the taper portion 12 and a portion of the LED 1 above taper portion 12 can be covered with the glass member 9. For example, in a case where a sapphire substrate of 0.635 mm is employed, which has a taper shape in a range of 0.5 mm from a face of the substrate on which a semiconductor 3 is provided, and provided that the shape of the glass member 9 is approximated by a sphere, the glass member of 1.0 mm in diameter can produce an output angle equivalent to that of a glass member of 1.5 mm in diameter.

Further, when the temperature is raised from the state of Fig. 5, the viscosity of the cover glass reduces, and the cover glass further moves downwardly. Then, when the cover glass 10 contacts with a wiring board 5, the cover glass 10 has a surface shape close to a spherical surface by its agglomeration. Thereafter, when its heating is stopped and it is cooled, a light-emitting device 13 having a structure shown in Fig. 7 can be obtained. Also in this case, a shape that the central axis $X_4$ of a cover glass 14 substantially agrees with the central axis $X_1$ of a LED 1 in a self-alignment manner. Further, in a light-emitting device 13 of Fig. 7, a cover glass 14 contains a portion 14a having a curved surface shape and a flat portion 14b.

Here, as described above, the heating temperature is determined according to the composition of the glass member 9, and at a given composition, the heating temperature is preferably set lower as the volume of glass member 9 is larger. When the volume of glass member 9 is large, the difference among times required for the glass member 9 to flow out from the upper face of the LED 1 through respective sides of the LED 1, or the difference among the amounts of the glass member 9 flowed out from the respective sides of the LED 1, increases. Further, the balance of the amount of glass member 9 covering respective faces of the LED 1 tends to be lost. For this reason, when the volume of the glass member 9 is large, in order to carry out the above self-alignment process, it is preferred to slowly soften the glass member 9 by a heat treatment of low temperature so that the glass member 9 moves downwardly along the LED 1 while the glass member 9 is balanced so as to cover the entirety of LED 1 uniformly.

Then, the directivity of a light-emitting device obtained in this embodiment is described.

A factor affecting directivity may, for example, be alignment of the central axis of LED to the central axis of cover glass, or the shape of cover glass.

As described above, according to this embodiment, a light-emitting device is obtained in which the central axis of LED substantially agrees with the central axis of cover glass. Namely, according to this embodiment, it is possible to produce a light-emitting device having high directivity. Further, since the above shape is obtainable in a self-alignment manner, it is not necessary to use e.g. a mold. Accordingly, it is possible to avoid defects such as deformation of an electrode portion of the LED due to such a mold occurred at a time of covering. Further, since there is no need of aligning the glass member to LED before heating, it is possible to improve productivity of light-emitting device.

Further, in the light-emitting device of Fig. 5, a LED 1 is embedded in a part of a cover glass 10 whose entirety is substantially spherical, and a curved face of the cover glass 10 contacts with side faces of the LED 1. Then, directivity of a light-emitting device 11 having such a structure will be discussed.

First, characteristic of light emitted from spherical surface is described.

In Fig. 10, a medium of refractive index n contacts with a medium of refractive index n' having a spherical surface. In this embodiment, the medium of refractive index n corresponds to air and the medium of refractive index n' corresponds to a glass.

In the medium of refractive index n', considering that a portion forming the spherical surface as a part of a sphere, the radius of the sphere is designated as r. Further, considering that the medium of refractive index n' as a lens, light is assumed to pass through the medium and output from the spherical surface into the medium of refractive index n. In this case, the focal length in the refractive index n' side is designated as f', and the focal length in the refractive index n side is designated as f. When an image MQ of an object M'Q' disposed at a position a distance S' from the spherical surface of the medium of refractive index n', is formed at a position in the medium of refractive index n a distance S from the spherical surface, the relation of formula (1) is satisfied.

$$(n/S) + (n'/S') = (n'-n)/r \qquad (1)$$

In formula (1), when n=1 and n'=2, the relation of formula (2) is satisfied.

$$(1/S) + (2/S') = 1/r \qquad (2)$$

Further, in formula (2), when S'=2r, S=∞ is satisfied. This means that light emitted from a point light source disposed on a surface of the spherical medium, transmitted and output from the spherical surface becomes parallel light.

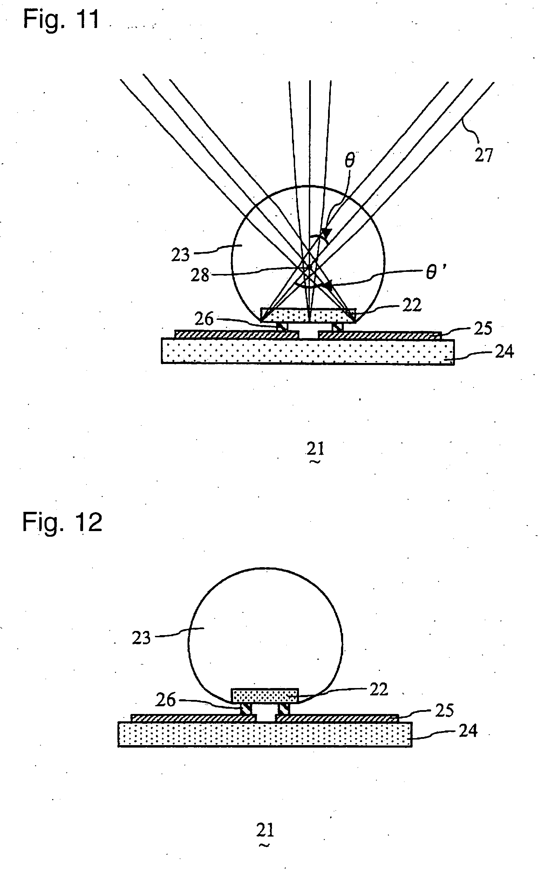

Fig. 11 is an example of cross-sectional view of a light-emitting device 1 of this embodiment. Further, Fig. 12 is a cross-sectional view of the light-emitting device 21 of Fig. 11 observed from a direction 45° shifted from the direction of Fig. 11. As shown in these Figs, a LED 22 is a semiconductor chip having a rectangular shape in a front view, and the LED 22 is electrically connected with wirings 25 on a wiring board 24 via bumps 26. Further, the light-emitting device 21 has a construction that the LED 22 is embedded in a part of a glass member 23 whose entirety is substantially spherical. Then, a curved surface of the glass member 23 contacts with a side face of the LED 22.

In the light-emitting device 21 of Figs. 11 and 12, a face of the LED 22 facing to the wiring board 24, that is, an electrode face has a rectangular shape. Then, Fig. 11 is a cross-sectional view along a diagonal line of the electrode face, and Fig. 12 is a cross-sectional view along a line passing through the center of the electrode face and at an angle of 45° to the diagonal line. Then the electrode face is considered so that each apex of its rectangular shape contacts with the curved face of the glass member 23. Accordingly, in Fig. 12, a lower part of the glass member 23 has slightly oblate shape as compared with that of Fig. 11.

LED 22 is provided with a light-emitting layer (not shown) in parallel with the electrode face, and light can be extracted mainly from a plane opposite to the electrode face.

Light 27 from LED 22 is, as schematically shown in Fig. 11, transmitted through the glass member 23 and output into the air. As described above, light emitted from a point light source disposed on a surface of a spherical medium, is transmitted through the medium, output from a spherical surface, and transformed into parallel light. Here, the position of the light-emitting layer of LED 22 is considered to be substantially equal to the position of the electrode face. Further, in Fig. 11, since the shape of glass member 23 can be assumed to be substantially spherical, light output from a contact point between LED 22 and the glass member 23, namely, from the vicinity of an apex of the electrode face, is considered as light from a point light source disposed on a surface of the spherical medium, then, light transmitted through the glass member 23 is considered to become parallel light. Further, at this time, the output angle $\theta$ is considered to be substantially equal to 1/2 of an angle $\theta'$ between light beams output from the vicinity of apexes of the electrode face and passing through the center 28 of the glass member 23.

Then, a case where the curved face of the glass member does not contact with the side face of LED, in other words, a case where each apex of the electrode face of the LED does not contact with the curved face of the glass member, is considered.

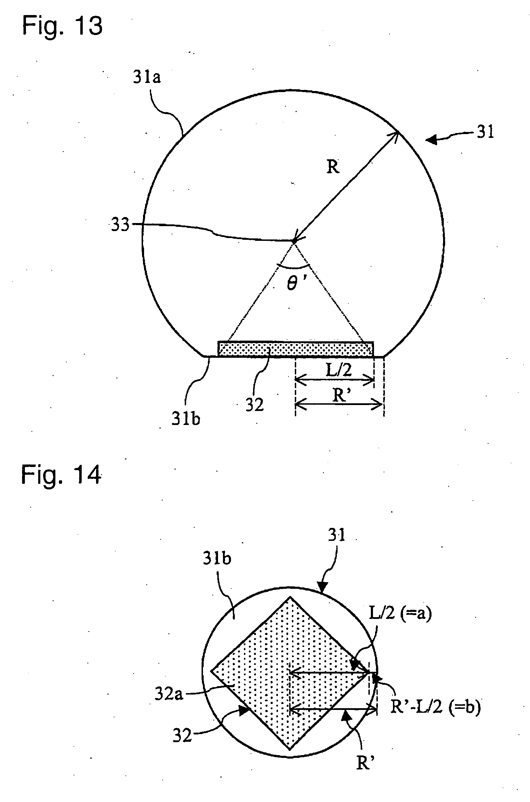

Fig. 13 is a partial cross-sectional view of the light-emitting device, which shows a structure that a LED is covered with a glass member. Further, Fig. 14 is a plan view of the light-emitting device of Fig. 13 observed from the LED side. Here, to facilitate understanding, Fig. 14 only shows a flat portion 31b of the glass member 31 to be described later, and a spherical surface portion 31a is omitted.

As shown in Figs. 13 and 14, the glass member 31 has a spherical surface portion 31a and a flat portion 31b. Then, a LED 32 is located at a flat portion 31b, and each apex of the electrode face 32a is disposed more inside from the spherical surface of the glass member 31.

Since the outer shape of the flat portion 31b can be regarded as circular, provided that the radius of this portion is designated as R' and the length of a diagonal line of the electrode face 32a is designated as L, the distance from an apex of the electrode face 32a to the spherical surface of the glass member 31 is represented by (R'-L/2). Then, in this specification, (L/2) is designated as "a" and (R-L/2) is designated as "b", so that the ratio of a portion of the glass member 31 protruding from the electrode face 32a is represented by (b/a).

When (b/a) is 0, there is no flat portion 31b and the construction becomes one corresponding to Figs. 11 and 12. Namely, the structure is such that entirety of the glass member has a substantially spherical shape, and a LED is embedded in a part of it, and further, a spherical surface portion of the glass member contacts with side faces of the LED.

Fig. 15 shows the relation between (b/a) and an angle $\theta'$ (=2$\theta$) of light output from the vicinity of an apex of the electrode face 32a and passing through the center of the glass member 31, that is obtained by calculation. Here, values of the angle $\theta'$ are specifically obtainable by the following manner.

As described above, L being the length of a diagonal line of the electrode face of the LED, can be obtained by actual measurement. Further, with respect to the glass sealing the LED, its spherical surface portion is considered to be a part of a sphere, and when the radius of the sphere is designated as R, also the R can be obtained by actual measurement.

Then, first of all, by multiplying (L/2) by an appropriate (b/a) value and adding (L/2) to the product, the radius R' of the flat portion of the glass member is obtained. Subsequently, the distance from the center of the glass member to the electrode face is obtained from the radius R and the radius R'. From the distance obtained and the radius R, a value of ($\theta'$/2) can be obtained, and by multiplying the value by 2, the angle $\theta'$ can be obtained.

Here, in the example of Fig. 15, the electrode face is assumed to be a square of 320 $\mu$m, and L is 453 $\mu$m. Further, the above calculation was made with respect to a case of the radius R=0.5 mm and a case of R=0.75 mm.

When (b/a) is not 0, an apex of the electrode face is not on the spherical surface, and accordingly, strictly speaking, light output from the vicinity of the apex does not become parallel light after it passes the spherical surface. Accordingly, even when (b/a) is equal to 0, from the structure shown in Fig. 11, 1/2 of the angle $\theta'$ can be regarded to be substantially equal to the output angle $\theta$, but as (b/a) increases, the difference between these values increase. However, since the output angle $\theta$ increases as the angle $\theta'$ increases, by studying the relation between the value of (b/a) and the angle $\theta'$, the relation between the value of (b/a) and the output angle $\theta$ can be presumed.

In Fig. 15, as the value of (b/a) increases, the angle $\theta'$ also increases. This is because in Fig. 13, as the distance b from an apex of the electrode face 32a to the spherical surface of the glass member 31 increases, the distance from the center 33 of the glass member 31 to the LED 32 decreases. Accordingly, as the value of (b/a) increases, the output angle $\theta$ increases and the directivity of light output from the LED 32 decreases.

Further, in Fig. 15, the angle $\theta'$ when (b/a) is 0 decreases as the value of the radius R increases. Accordingly, it is considered that as the glass member 31 sealing the LED 32 is larger, the output angle $\theta$ becomes smaller and the directivity increases. On the other hand, as the value of the radius R is larger, change of the angle 2$\theta$ by the change of (b/a) is smaller. From these results, decrease of directivity by the increase of the distance b from the top of the electrode face 32a to the spherical surface of the glass member 31, becomes smaller as the glass member 31 stealing the LED 32 becomes larger.

Thus, the output angle θ being an index of directivity correlates to an angle θ' between light beams output from the vicinity of apexes of the electrode face of LED and passing the center of glass member. Here, provided that the ratio of protrusion of glass member from the electrode face is represented by (b/a), the angle θ' increases as the value of (b/a) increases. Namely, by changing the value of (b/a), the angle θ' can be changed, and as a result, the output angle θ can be changed. This means that the directivity can be controlled by the value of (b/a). For example, when the value of (b/a) is increases, the output angle θ increases, and accordingly, the directivity of light emitted from the LED decreases. Accordingly, even without providing a cavity, only by changing the value of (b/a), it becomes possible to provide a light-emitting device having a required output angle θ.

According to the above feature, when the value of (b/a) is 0, namely, when the device has a structure that the curved surface of glass member contacts with side faces of the LED, particularly high directivity can be achieved. Further, the directivity increases as the shape of glass member covering a LED close to a sphere. The light-emitting device (Fig. 5) obtainable in this embodiment, has a construction in which a LED 1 is embedded in a part of a cover glass 10 whose entirety is substantially spherical, and a curved surface of the cover glass 10 contacts with side faces of the LED 1, and accordingly, it is possible to achieve high directivity without a cavity. Accordingly, the light-emitting device is suitable for an application of e.g. a light source for optical fibers or projectors.

In the light-emitting device of Fig. 5, the surface shape of the cover glass 10 is approximated by a sphere, and the radius of the sphere is designated as R. Further, the length of a diagonal line in the electrode face of the LED 1 is designated as L. Here, the shape of the electrode face, that is the shape of a substrate 2 constituting the LED 1, is a rectangle in a front view. Here, when the shape of the substrate 2 is a rhombic shape or a parallelogram in a front view, L indicates the length of diagonal lines whichever longer. At this time, when the relation of formula (3) is satisfied, a light-emitting device having particularly high directivity and excellent also in light-extraction efficiency can be obtained.

$$L < 2R \leqq 3L \qquad (3)$$

When the shape of the electrode face is a rectangle in a front view, in a cross section of the light-emitting device along a plane containing a diagonal line of the rectangle and the center of the cover glass, the diameter of the cover glass equals to the diameter 2R of the above sphere. Meanwhile, when the shape of the electrode face is a rhombic shape or a parallelogram, a cross section of the light-emitting device along a plane containing one of the diagonal lines whichever longer of the rhombic shape or the parallelogram and the center of the cover glass, the diameter of the cover glass equals to the diameter 2R of the above sphere. Accordingly, in each of these cases, entirety of the LED except the electrode face can be covered by a cover glass when L<2R is satisfied.

In the above cases, when the diameter of the cover glass becomes close to the length L of a diagonal line of LED, the shape of the cover glass becomes a shape close to a semisphere. On the other hand, when the diameter of the cover glass becomes larger than the length of the diagonal line of LED, the shape of the cover glass changes from a shape close to a semisphere to a shape close to a sphere. Accordingly, the directivity increases as 2R increases relatively to L. However, when 2R is too large, there increases difference among respective sides of the LED in terms of time at which the glass member flows out from the upper face of the LED or in the amount of glass member flows out when the glass member is softened, and accordingly, the balance of the amount of glass member covering the respective faces of LED tends to be lost. As a result, it becomes difficult to obtain a shape wherein the central axis of the LED substantially agrees with the central axis of cover glass. For this reason, 2R is preferably at most a predetermined value, and according to study of the present inventors, it is preferred that a relation 2R≦3L is satisfied.

Here, the present invention is not limited to the above embodiments, and it can be worked with various types of modifications within a range not departing from the gist of the present invention.

For example, in this embodiment, after the LED 1 is covered with a cover glass 10, as shown in Fig. 16, a sealing resin 15 may be provided between the cover glass 10 with the LED 1 and the wiring board 5. By this construction, it is possible to prevent moisture from penetrating from the outside through a gap between these members. Further, since the cover glass 10 is supported by the sealing resin 15, it becomes possible to stably retain the cover glass 10. For this purpose, the sealing resin 15 is preferably one having low moisture-absorption property and at least a certain extent of mechanical strength..Here, the sealing resin 15 may be any one of UV curable type and a thermosetting type (for example, an acrylic resin or an epoxy resin), but from the viewpoint of high curing speed or low impact on members around the resin, a resin of UV-curable type is preferably employed.

Further, in the light-emitting device 13 of Fig. 7, a sealing resin similar to the above may be provided.

From now, Example of the present invention is described.

EXAMPLE

PREPARATION OF WIRING BOARD

As a substrate, an alumina substrate having a purity of 99.6% and a thickness of 1 mm was employed. Then, a gold paste for wiring was prepared. Specifically, gold (80 wt%) and an organic varnish (18 wt%) were blended, kneaded for 1 hour in a porcelain mortar, and dispersion was carried out three times by employing three rolls to produce a gold paste.
As the gold, a fine particle powder of spherical shape having an average particle size of 2 $\mu$m was employed. Further, as the organic varnish, one prepared by dissolving an ethyl cellulose resin of polymerization degree 7 was dissolved in $\alpha$-terpineol so that the concentration of the resin was 20 wt%, was employed.
Then, a wiring pattern was formed by screen printing the gold paste on the surface of the alumina substrate. Thereafter, the alumina substrate was subjected to a heating treatment at 120°C for 10 minutes, and baked at 800°C for 30 minutes to prepare gold wirings on the alumina substrate.

LED

E1C60-0B011-03 (product name) manufactured by Toyoda Gosei Co., Ltd. was employed. The electrode face of this LED is a square of 320 $\mu$m, and its L=453 $\mu$m.

BONDING

First of all, total two bumps were formed on electrodes of the LED. Specifically, by using a manual wire bonder (product name 7700D) manufactured by Westbond Inc., gold bumps were formed from a gold wire of 25 $\mu$m in diameter (SGH-25 (product name) manufactured by Sumitomo Metal Mining Co., Ltd.). The gold bumps formed each has a diameter of 100 $\mu$m and a height of 25 $\mu$m.
Then, the electrodes provided in the LED and gold wirings were bonded via two gold bumps. At this time, in order to make the LED parallel with the substrate, the bonding was carried out while a predetermined pressure was applied. Specifically, by using a flip chip bonder (product name MOA-500) manufactured by Hisol Inc., the LED was flip-chip mounted on the alumina substrate. The diameter of gold bumps after bonding was about 100 $\mu$m, and their height was about 20 $\mu$m to 30 $\mu$m.

COVERING WITH GLASS MEMBER

As a glass member, one composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), $ZnO$ (15 mol%), $Y_2O_3$ (0.5 mol%), $La_2O_3$ (0.5 mol%), $Gd_2O_3$ (3.0 mol%) and $Ta_2O_5$ (3.0 mol%), was employed.
Then, the glass member was fabricated into a block shape having an appropriate size, and placed on the LED that was flip-chip mounted. At this time, the mounting was carried out so that the central axis of the glass member mounted on the LED is present in a region from the central axis of the LED to a position inside of the periphery of LED, and that the area of this region becomes at most 90% of the area of the entire plane on which the glass member is placed.
Then, a heat treatment was carried out.
As a heating apparatus, an electric furnace (model name FP41) manufactured by Yamato Scientific Co., Ltd. or an infrared-condensing heating apparatus IVF298W (product name) manufactured by Thermo Riko Co., Ltd. was employed.
With the electric furnace (model name FP41) manufactured by Yamato Scientific Co., Ltd., the temperature was raised from 25°C at a speed of 5°C/min, and maintained at 610°C for 15 min. Thereafter, it was lowered to 25°C at a speed of 5°C/min. By this operation, light-emitting devices (No. 1 to 6 in Table 1) each having a structure equivalent to that of Fig. 5, were obtained.
Meanwhile, the infrared-condensing heating apparatus IVF298W (product name) of Thermo Riko CO., Ltd. has an infrared lamp having a radiation wavelength band of from 600 nm to 1,100 nm and a maximum radiation intensity in the vicinity of 900 nm.
In a chamber of the infrared-condensing heating apparatus, an aluminum titanate ($Al_2O_3 \cdot TiO_2$) (product name: Lotec TM) manufactured by Asahi Glass Ceramics Co., Ltd. having a diameter of 20 mm was placed as an infrared-absorbing member, the wiring board on which the LED was mounted was placed on the infrared-absorbing member, and the above glass member was placed on the LED. Then, irradiation of infrared rays of 2 kW output power was made from the infrared-absorbing member side. The temperature profile was such that the temperature was raised from a room temperature to 630°C in 15 min, it was maintained at 630°C for about 30 sec to 1 min 50 sec, and lowered to a room temperature in 5 min. Here, the temperature was measured by contacting the ceramics with a thermocouple. By this process, light-emitting devices (No. 7 and 8 in Table 1) each having a structure equivalent to that of Fig. 5 were obtained.

Table 1 shows evaluation results of displacement between the central axis of LED and the central axis of the cover glass. In the Table, measurement A and measurement B indicate results of measurement of each light-emitting device from directions 90° different from each other.

In measurement A, $R_1$ indicates the diameter of a sphere when the surface shape of a cover glass is approximated by the sphere and the diameter is measured in a cross section of the light-emitting device along a plane containing one of diagonal lines of an electrode face of LED and the center of the cover glass. Further, $L_1$ is the length of the above one of the diagonal lines, and $h_1$ is a height of the center of the sphere from the electrode face of LED. Further, $\delta_1$ is a displacement between the symmetric axis of the cover glass and the symmetric axis of LED chip.

In measurement B, $R_2$ indicates the diameter of a sphere when the surface shape of a cover glass is approximated by the sphere and the diameter is measured in a cross section of the light-emitting device along a plane containing the other one of diagonal lines of an electrode face of LED and the center of the cover glass. Further, $L_2$ is the length of said the other one of the diagonal lines, and $h_2$ is a height of the center of the sphere from the electrode face of LED. Further, $\delta_2$ is a displacement between the symmetric axis of the cover glass and the symmetric axis of LED chip.

TABLE 1

| No. | Measurement A | | | | Measurement B | | | | $(\delta_1{}^2+\delta_2{}^2)^{1/2}$ |
|---|---|---|---|---|---|---|---|---|---|
| | $R_1$ | $L_1$ | $h_1$ | $\delta_1$ | $R_2$ | $L_2$ | $h_2$ | $\delta_2$ | |
| 1 | 1008.9 | 412.0 | 432.3 | 3.1 | 1007.8 | 391.4 | 445.1 | −9.1 | 9.6 |
| 2 | 986.7 | 412.0 | 438.3 | −3.1 | 995.1 | 402.3 | 440.1 | −3.9 | 5.0 |
| 3 | 1013.3 | 412.0 | 447.9 | −3.1 | 1013.3 | 407.8 | 444.3 | −9.6 | 10.1 |
| 4 | 745.6 | 425.8 | 308.6 | 1.3 | 744.3 | 436.7 | 310.9 | −2.9 | 3.1 |
| 5 | 753.4 | 414.8 | 310.9 | −5.2 | 749.7 | 409.4 | 314.6 | −4.7 | 7.0 |
| 6 | 547.9 | 454.7 | 196.6 | 9.1 | 547.9 | 447.9 | 204.4 | −7.8 | 12.0 |
| 7 | 749.2 | 438.3 | 318.0 | 6.5 | 745.6 | 424.5 | 326.6 | −32.6 | 33.2 |
| 8 | 749.7 | 438.3 | 315.1 | 36.2 | 745.6 | 429.9 | 318.8 | −22.4 | 42.6 |

Unit: all μm

In the entire light-emitting device, the displacement between the central axis of LED and the central axis of cover glass is evaluated according to a value of $(\delta_1{}^2+\delta_2{}^2)^{1/2}$. When the electric furnace is used, the displacement was in the vicinity of 10 μm in each of the samples (No. 1 to 6). On the other hand, in samples (NO. 7 and 8) for which the infrared-condensing heating apparatus was used, the displacements were larger than those of the samples for which the electric furnace was used, but the displacement values were in the vicinity of 5% of the diameter of cover glass. Accordingly, it is understood that according to this embodiment, a light-emitting device having a shape that the central axis of LED substantially agrees with the central axis of cover glass in a self-alignment manner.

INDUSTRIAL APPLICABILITY

The present invention can provide a light-emitting device in which a light-emitting element is covered with a glass member, and which is applicable to light sources, illumination devices and light-emitting devices.

The entire disclosure of Japanese Patent Application No. 2006-139527 filed on May 18, 2006 including specification, claims, drawings and summary is incorporated herein by reference in its entirety.

**Claims**

1. A process for producing light-emitting device comprising a step of preparing a light-emitting element mounted on a wiring board, a step of placing on the light-emitting element a glass member approximated by a rectangular solid or a sphere, and a step of softening the glass member by a heating treatment, wherein the central axis of the glass member placed on the light-emitting element is located in a region centered at the central axis of the light-emitting element and ranging to a position inside from the periphery of the light-emitting element, the area of the region is at most 90% of the area of the entire surface on which the glass member is mounted, and the step of softening the glass member is a step of covering the light-emitting element with the glass member to thereby forming a shape in which the central axis of the light-emitting element substantially agrees with the central axis of the glass member by a self-alignment manner.

2. A process for producing light-emitting device comprising a step of preparing a light-emitting element mounted on a wiring board, a step of providing a glass paste on the light-emitting element, a step of baking the glass paste to form a glass member, and a step of softening the glass member by a heating treatment, wherein the step of softening the glass member is a step of covering the light-emitting element with the glass member to thereby forming a shape in which the central axis of the light-emitting element substantially agrees with the central axis of the glass member by a self-alignment manner.

3. A process for producing light-emitting device comprising a step of preparing a light-emitting element mounted on a wiring board, a step of placing a green sheet on the light-emitting element, a step of baking the green sheet to form a glass member, and a step of softening the glass member by a heating treatment, wherein the step of softening the glass member is a step of covering the light-emitting element with the glass member to thereby forming a shape in which the central axis of the light-emitting element substantially agrees with the central axis of the glass member by a self-alignment manner.

4. The process for producing light-emitting device according to any one of Claims 1 to 3, wherein the step of preparing a light-emitting element mounted on a wiring board comprises a step of preparing a light-emitting element having a substrate, a semiconductor layer on the substrate and an electrode for applying voltage to the semiconductor layer, and a step of mounting the light-emitting element on the wiring board so that the angle between the substrate and the wiring board becomes at most 1°.

5. The process for producing light-emitting device according to any one of Claims 1 to 3, wherein the step of mounting a light-emitting element on a wiring board is a step of electrically connecting the electrode with the wiring board via bumps, and the number of bumps is at least 3.

6. The process for producing light-emitting device according to any one of Claims 1 to 5, wherein the light-emitting element comprises a substrate and a semiconductor layer provided on the substrate; a side face of the substrate has a taper portion within a predetermined vertical range from the face of the substrate on which the semiconductor layer is provided; and the step of softening glass member is a step of covering with the glass member the taper portion of the substrate and a portion above the taper portion.

7. The process for producing light-emitting device according to any one of Claims 1 to 6, wherein the glass member contains $TeO_2$, $B_2O_3$ and ZnO as main components.

8. The process for producing light-emitting device according to any one of Claims 1 to 7, wherein the light-emitting element is any one of an LED and a semiconductor laser.

9. A light-emitting device comprising a wiring board; a light-emitting element having a substrate of rectangular shape in a front view, a semiconductor layer on the substrate, and an electrode electrically connected with the wiring board and for applying voltage to the semiconductor layer; and a glass member for covering the light-emitting element; wherein entirety of the glass member is substantially spherical, the light-emitting element is embedded in a part of the glass member, a curved face of the glass member contacts with a side face of the light-emitting element, and a radius R of a sphere approximating the glass member and the length L of a diagonal line of the substrate satisfy a relation:

$$L < 2R \leqq 3L.$$

10. A light-emitting device comprising a wiring board; a light-emitting element having a substrate of rhombic shape or parallelogram shape in a front view, a semiconductor layer on the substrate, and an electrode electrically connected with the wiring board and for applying voltage to the semiconductor layer; and a glass member for covering the light-emitting element; wherein entirety of the glass member is substantially spherical, the light-emitting element is embedded in a part of the glass member, a curved face of the glass member contacts with a side face of the light-emitting element, and a radius R of a sphere approximating the glass member and the length L of one of diagonal lines whichever longer of the substrate satisfy a relation:

L<2R≦3L.

11. The light-emitting device according to Claim 9 or 10, wherein the glass member contains $TeO_2$ $B_2O_3$ and ZnO as main components.

12. The light-emitting device according to any one of Claims 9 to 11, wherein the light-emitting element is any one of an LED and a semiconductor laser.

Fig. 1

```
┌─────────────────────┐
│ MOUNT LED ON        │        STEP 1
│ WIRING BOARD        │
└─────────────────────┘
           │
           ▼
    ┌─────────────┐
    │ PREPARE     │            STEP 2
    │ GLASS MEMBER│
    └─────────────┘
           │
           ▼
┌─────────────────────────┐
│ PLACE GLASS MEMBER ON   │    STEP 3
│ LED                     │
└─────────────────────────┘
           │
           ▼
    ┌─────────────┐
    │ HEAT        │            STEP 4
    │ TREATMENT   │
    └─────────────┘
```

Fig. 2

Fig. 3

(a)

(b)

Fig. 4

## Fig. 5

## Fig. 6

Fig. 7

13

Fig. 8

101

## Fig. 9

## Fig. 10

## Fig. 11

## Fig. 12

Fig. 13

Fig. 14

Fig. 15

Fig. 16

Fig. 17

## INTERNATIONAL SEARCH REPORT

| International application No. |
| --- |
| PCT/JP2006/319985 |

**A. CLASSIFICATION OF SUBJECT MATTER**
*H01L33/00*(2006.01)i, *C03C3/14*(2006.01)i

According to International Patent Classification (IPC) or to both national classification and IPC

**B. FIELDS SEARCHED**

Minimum documentation searched (classification system followed by classification symbols)
H01L33/00, C03C3/14

Documentation searched other than minimum documentation to the extent that such documents are included in the fields searched
Jitsuyo Shinan Koho           1922-1996   Jitsuyo Shinan Toroku Koho   1996-2006
Kokai Jitsuyo Shinan Koho     1971-2006   Toroku Jitsuyo Shinan Koho   1994-2006

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2000-353824 A  (Stanley Electric Co., Ltd.), 19 December, 2000 (19.12.00), Full text; all drawings (Family: none) | 1-12 |
| A | JP 2002-305328 A  (Nichia Chemical Industries, Ltd.), 18 October, 2002 (18.10.02), Full text; all drawings (Family: none) | 1-12 |

☐ Further documents are listed in the continuation of Box C.   ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 19 October, 2006 (19.10.06) | 31 October, 2006 (31.10.06) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8102553 A
- WO 2004082036 A
- JP 2006054210 A
- JP 2006054209 A
- JP 2002151737 A
- JP 10303407 A
- JP 2005136415 A
- JP 2005254127 A
- JP 2006111089 A
- JP 2006072612 A
- JP 2006139527 A